# EUROPEAN PATENT APPLICATION

(11) **EP 4 788 113 A1**
(43) Date of publication of application: **05.08.2026**
(21) Application number: 26153991.0
(22) Date of filing: 26.01.2026
(51) Int. Cl.: H10P 72/00

(54) **SUBSTRATE PROCESSING APPARATUS**

(30) Priority: 30.01.2025 JP 2025014061
(71) Applicant: SCREEN Holdings Co., Ltd., Kyoto-shi, Kyoto 602-8585 (JP)
(72) Inventor: NISHIMURA, Junki, Kyoto, 602-8585 (JP)
(74) Representative: Kilian Kilian & Partner mbB

(57) **Abstract**

A substrate processing apparatus includes three processing casings stacked in a vertical direction. Each of the three processing casings includes, in an internal space, a spin chuck, an ejection unit, a cup that receives a coating liquid scattered from a substrate held by the spin chuck, a cup drainage flow path that is formed to extend vertically downward from the cup and that discharges the coating liquid received by the cup, a casing drainage flow path formed to extend in the vertical direction, and a connection flow path that connects a lower end of the cup drainage flow path and the casing drainage flow path. The respective casing drainage flow paths of the three processing casings are connected as the three processing casings are stacked in the vertical direction.

## Description

### BACKGROUND

### Technical Field

The present invention relates to a substrate processing apparatus that processes a substrate. Examples of the substrate include a semiconductor substrate, a substrate for a flat panel display (FPD), a glass substrate for a photomask, a substrate for an optical disk, a substrate for a magnetic disk, a ceramic substrate, and a substrate for a solar cell. Examples of the FPD include a liquid crystal display device and an organic electroluminescence (EL) display device.

### Related Art

A conventional substrate processing apparatus (substrate processing system) includes a plurality of processing units (see, for example, JP 2002-305134 A). Each of the processing units includes a processing main body and a liquid recovery unit disposed below the processing main body.

The processing main body includes a spin chuck that holds a substrate, a nozzle that ejects a processing liquid (for example, a resist liquid) to the substrate, and a cup that receives the processing liquid scattered from the substrate. A drain pipe for discharging the processing liquid is provided at a bottom of the cup of the processing main body. The drain pipe extends downward from the cup to the liquid recovery unit (JP 2002-305134 A and JP 2002-261065 A).

JP 2024-103760 A discloses a substrate processing apparatus including a processing unit, a first pipe space, and a second pipe space. The processing unit includes a processing casing and a holding unit that is disposed inside the processing casing and holds a substrate. In plan view, the first pipe space, the processing casing, and the second pipe space are arranged in this order. The first pipe space accommodates an exhaust pipe. The second pipe space accommodates a pipe for discharging a processing liquid from the processing unit. However, JP 2024-103760 A does not disclose details of the pipe through which the processing liquid is discharged.

JP 2020-043158 A discloses that a processing liquid supplied to a substrate flows into a drainage path provided in a lower portion of a cup and is recovered or discarded.

### SUMMARY

However, the conventional substrate processing apparatus has the following problems. As in JP 2002-305134 A and JP 2002-261065 A described above, each processing unit includes the processing main body and the liquid recovery unit. For example, it is assumed that the two processing units are stacked and a liquid recovery tank is disposed below the two processing units. In this case, the liquid recovery tank, a first liquid recovery unit, a first processing main body, a second liquid recovery unit, and a second processing main body are stacked in this order in an upward direction.

In order to feed the processing liquid to the liquid recovery tank of the lowermost layer, the conventional substrate processing apparatus is configured as follows. In the lower processing unit, a first drain pipe of the first processing main body extends downward from the first processing main body to the first liquid recovery unit.

On the other hand, in the upper processing unit, a second drain pipe of the second processing main body extends downward from the second processing main body to the second liquid recovery unit. The second drain pipe extends from the second liquid recovery unit to the first liquid recovery unit while bypassing the cup or the like of the first processing main body. Both the first drain pipe and the second drain pipe are connected to the liquid recovery tank while extending from the first liquid recovery unit to the liquid recovery tank.

For example, when the second drain pipe passes through an inside of the first processing main body when the second drain pipe extends from the second liquid recovery unit to the first liquid recovery unit, the first processing main body and the second processing main body have different structures (designs). Therefore, different structures are required for the first liquid recovery unit, the first processing main body, the second liquid recovery unit, and the second processing main body. Even when the second drain pipe passes through an outside of the first processing main body, the first liquid recovery unit and the second liquid recovery unit have different structures. Therefore, there is a demand for further simplifying these structures, particularly, a liquid recovery pipe structure (drainage structure).

When a path of a drain pipe is long, it is difficult to recover a processing liquid. In particular, as a viscosity of a processing liquid (coating liquid) is higher, the processing liquid is less likely to flow. A processing liquid having a high viscosity is used, for example, for manufacturing a power device. The viscosity of this processing liquid is, for example, 500 to 20000 centipoise (cP). Therefore, there is a demand for improving recovery efficiency of a processing liquid.

The present invention has been made in view of such circumstances, and an object of the present invention is to provide a substrate processing apparatus capable of efficiently recovering a processing liquid while simplifying a drainage structure.

In order to achieve such an object, the present invention has the following configuration. That is, a substrate processing apparatus that processes a substrate, according to the present invention, includes a plurality of processing casings stacked in a vertical direction, in which each of the plurality of processing casings includes, in an internal space, a chuck configured to hold a substrate, an ejection unit configured to eject a processing liquid to the substrate held by the chuck, a cup formed to surround an outer peripheral edge of the chuck, and configured to receive the processing liquid scattered from the substrate held by the chuck, a cup drainage flow path formed to extend vertically downward from the cup, and configured to discharge the processing liquid received by the cup, a casing drainage flow path formed to extend in the vertical direction, and a connection flow path connecting a lower end of the cup drainage flow path and the casing drainage flow path, and the respective casing drainage flow paths of the plurality of processing casings are connected as the plurality of processing casings are stacked in the vertical direction.

According to the substrate processing apparatus according to the present invention, the casing drainage flow path formed to extend in the vertical direction is provided in the internal space of each processing casing. The plurality of casing drainage flow paths of the plurality of processing casings are connected. That is, when the plurality of processing casings are stacked, the plurality of casing drainage flow paths are connected. Therefore, a drainage structure can be simplified. In addition, since the casing drainage flow path is provided in the internal space, the casing drainage flow path can be close to the cup in a horizontal direction and the connection flow path can be shortened, as compared with a case where the casing drainage flow path is provided outside the processing casing and the casing drainage flow path bypasses the lower processing casing. In addition, each of the plurality of casing drainage flow paths extends in the vertical direction, and the respective casing drainage flow paths extending in the processing casings are connected in the vertical direction, whereby the casing drainage flow paths do not need to bypass the processing casings. Therefore, the flow of the processing liquid is facilitated while shortening each casing drainage flow path. Thus, the processing liquid can be efficiently recovered.

Further, in the substrate processing apparatus described above, the connection flow path is preferably formed to be inclined downward and in a direction toward the casing drainage flow path. For example, in a case where the processing liquid has a high viscosity, when the connection flow path extends in the horizontal direction, it is particularly difficult to cause the processing liquid having the high viscosity to flow. According to the present invention, since the connection flow path is inclined, it is possible to facilitate the flow of the processing liquid.

Further, in the substrate processing apparatus described above, the connection flow path is preferably formed to extend linearly. Since the connection flow path extends linearly, the connection flow path can be shortened.

Further, in the substrate processing apparatus described above, it is preferable that each of the plurality of processing casings further includes, in the internal space, a standby pot provided between the cup and the casing drainage flow path, the standby pot configured to cause the ejection unit to stand by, and configured to receive the processing liquid ejected from the ejection unit, and a standby pot drainage flow path configured to discharge the processing liquid received by the standby pot, and the standby pot drainage flow path is connected to the connection flow path between the cup drainage flow path and the casing drainage flow path.

For example, as a comparative example, when the standby pot, the cup, and the casing drainage flow path are arranged in this order, the connection flow path becomes long. In the present invention, the connection flow path can be shortened.

Further, in the substrate processing apparatus described above, the cup drainage flow path, the standby pot drainage flow path, and the casing drainage flow path are preferably arranged on a straight line in plan view. Accordingly, since the connection flow path can be formed linearly, the connection flow path can be shortened.

Further, in the substrate processing apparatus described above, the standby pot drainage flow path is preferably formed to extend vertically downward from the standby pot. As a result, the flow of the processing liquid is facilitated while shortening the standby pot drainage flow path.

Further, in the substrate processing apparatus described above, it is preferable that each of the plurality of processing casings includes a cleaning liquid ejection unit that ejects a cleaning liquid to the connection flow path, and the cleaning liquid ejection unit is provided at a proximal end portion of the connection flow path to which the cup drainage flow path is connected. The connection flow path is a flow path that connects the lower end of the cup drainage flow path and the casing drainage flow path. Since the cleaning liquid ejection unit is provided at the proximal end portion of the connection flow path to which the cup drainage flow path is connected, the cleaning liquid can be ejected from the most upstream side of the connection flow path. Therefore, the cleaning liquid can be supplied to the entire connection flow path, and the processing liquid in the connection flow path can suitably flow.

Further, in the substrate processing apparatus described above, it is preferable that the plurality of processing casings include a first processing casing, and a second processing casing disposed on an upper portion of the first processing casing, the first processing casing includes a first bottom wall that defines a lower surface of a first internal space that is the internal space of the first processing casing, and a ceiling wall that defines an upper surface of the first internal space, the first bottom wall includes a first bottom hole, the ceiling wall includes a ceiling hole, the casing drainage flow path of the first processing casing includes a lower drainage flow path attached to the first bottom hole, and formed to extend vertically upward from the first bottom hole, and an upper drainage flow path capable of expanding and contracting, the upper drainage flow path detachably attached to the ceiling hole and formed to extend vertically downward from the ceiling hole, and an upper end of the lower drainage flow path is separably coupled to a lower end of the upper drainage flow path.

The casing drainage flow path of the first processing casing includes the lower drainage flow path extending vertically upward from the bottom hole of the bottom wall and the upper drainage flow path extending vertically downward from the ceiling hole of the ceiling wall. The upper end of the lower drainage flow path is separably coupled to the lower end of the upper drainage flow path. The upper drainage flow path is detachably attached to the ceiling hole of the ceiling wall. For example, in maintenance of the substrate processing apparatus, there is a case where the upper drainage flow path and the lower drainage flow path are separated, and then the upper drainage flow path is detached from the ceiling hole of the ceiling wall. Since the upper drainage flow path can expand and contract, a sufficient gap can be secured between the upper drainage flow path and the lower drainage flow path. Therefore, the upper drainage flow path can be easily detached from the ceiling hole of the ceiling wall.

Further, in the substrate processing apparatus described above, it is preferable that the second processing casing is at a highest position among the plurality of processing casings, the second processing casing includes a second bottom wall that defines a lower surface of a second internal space that is the internal space of the second processing casing, the second bottom wall includes a second bottom hole, and the casing drainage flow path of the second processing casing includes a lower drainage flow path attached to the second bottom hole, and formed to extend vertically upward from the second bottom hole, and a lid member configured to close an upper end of the lower drainage flow path.

The second processing casing is at the highest position among the plurality of processing casings. In this case, the casing drainage flow path of the first processing casing includes the lower drainage flow path and the upper drainage flow path. On the other hand, the casing drainage flow path of the second processing casing includes the lower drainage flow path and the lid member. In other words, the casing drainage flow path of the second processing casing includes the lid member instead of the upper drainage flow path. Therefore, the first processing casing can be easily changed to the second processing casing.

Further, in the substrate processing apparatus described above, it is preferable that each of the plurality of processing casings further includes a first side wall and a second side wall that define two side surfaces of the internal space and face each other, the cup is disposed closer to the first side wall than the second side wall, and the casing drainage flow path is disposed on an opposite side of the first side wall with the cup interposed therebetween.

For example, as a comparative example, it is assumed that the first side wall, the cup, the second side wall, and the casing drainage flow path are arranged in this order in the horizontal direction. That is, it is assumed that the casing drainage flow path is disposed outside the processing casing. In the case of this comparative example, when the cup is disposed closer to the first side wall than the second side wall, the connection flow path becomes longer, and it is difficult to secure the inclination of the connection flow path. According to the present invention, the casing drainage flow path is disposed in the internal space (inside the processing casing). Therefore, the connection flow path can be shortened, and the inclination of the connection flow path can be secured.

Further, in the substrate processing apparatus described above, it is preferable that each of the plurality of processing casings further includes, in the internal space, a second chuck configured to hold a second substrate, a second cup formed to surround an outer peripheral edge of the second chuck, and configured to receive the processing liquid scattered from the second substrate held by the second chuck, a second cup drainage flow path formed to extend vertically downward from the second cup, and configured to discharge the processing liquid received by the second cup, and a second connection flow path connecting a lower end of the second cup drainage flow path and the casing drainage flow path.

Even when each of the plurality of processing casings includes the second chuck and the second cup, the processing liquid can be efficiently recovered while simplifying the drainage structure.

Further, in the substrate processing apparatus described above, an example of the ejection unit is configured to eject a coating liquid as the processing liquid to the substrate held by the chuck. This configuration enables the coating liquid to be recovered efficiently.

Further, in the substrate processing apparatus described above, the respective casing drainage flow paths provided in the plurality of processing casings are preferably arranged so as to at least partially overlap each other in plan view. It is possible to facilitate the flow of the coating liquid while shortening each casing drainage flow path. Therefore, the coating liquid can be efficiently recovered.

Further, in the substrate processing apparatus described above, the respective casing drainage flow paths of the plurality of processing casings are preferably linearly connected as the plurality of processing casings are stacked in the vertical direction. It is possible to facilitate the flow of the coating liquid while shortening each casing drainage flow path. Therefore, the coating liquid can be efficiently recovered.

According to the substrate processing apparatus of the present invention, it is possible to efficiently recover the processing liquid while simplifying the drainage structure.

### BRIEF DESCRIPTION OF DRAWINGS

FIG. 1 is a plan view of a substrate processing apparatus according to a first embodiment;
FIG. 2 is a longitudinal sectional view illustrating three processing casings and a liquid recovery layer;
FIG. 3 is a longitudinal sectional view of the processing casing that is not in the uppermost layer;
FIG. 4 is a transverse sectional view of the processing casing that is not in the uppermost layer;
FIG. 5 is a longitudinal sectional view mainly illustrating a drainage structure of the processing casing that is not in the uppermost layer;
FIG. 6 is a sectional view of a connection flow path taken along line B-B in FIG. 5;
FIG. 7 is a longitudinal sectional view of the processing casing of the uppermost layer;
FIG. 8 is a flowchart illustrating an example of a substrate processing operation by the substrate processing apparatus;
FIG. 9 is a longitudinal sectional view for describing a first path for causing a cleaning liquid to flow from a cup to a casing drainage flow path;
FIG. 10 is a longitudinal sectional view for describing a second path for causing the cleaning liquid to flow from a standby pot to the casing drainage flow path;
FIG. 11 is a longitudinal sectional view for describing a third path for causing the cleaning liquid to flow from an ejection flow path to the casing drainage flow path;
FIG. 12 is a longitudinal sectional view for describing a maintenance method of the substrate processing apparatus;
FIG. 13 is a longitudinal sectional view illustrating two processing units stacked in a vertical direction of a conventional substrate processing apparatus as a comparative example; and
FIG. 14 is a schematic diagram illustrating three processing casings and a liquid recovery layer stacked in the vertical direction according to a second embodiment.

### DETAILED DESCRIPTION

Hereinafter, embodiments of the present invention will be described.

### [First embodiment]

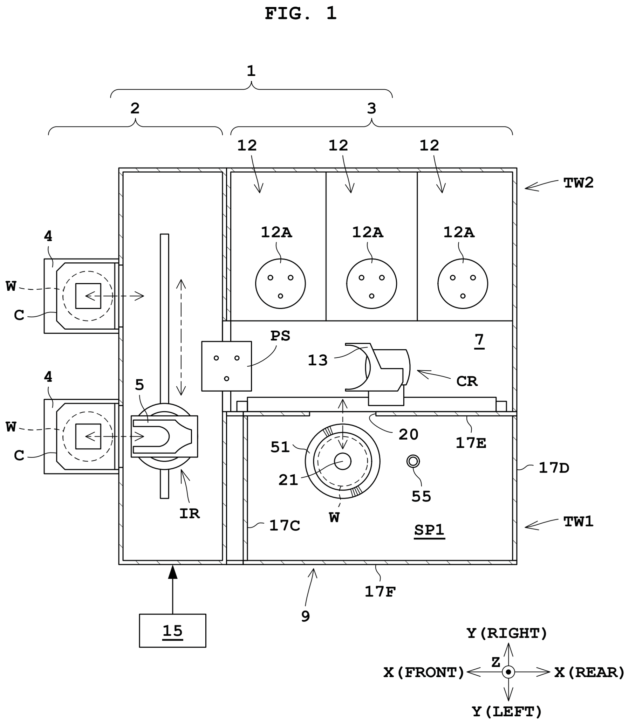

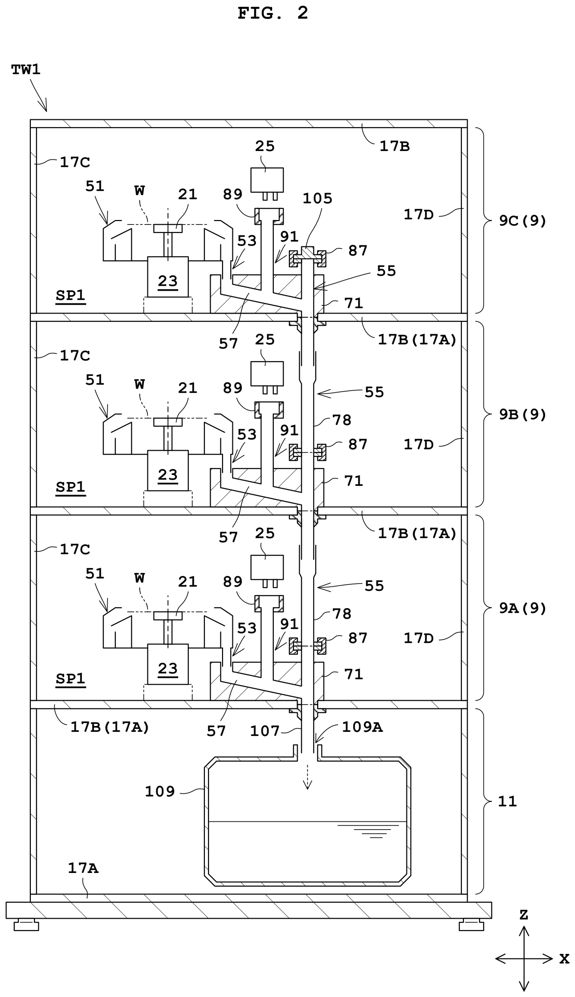

Hereinafter, a first embodiment of the present invention will be described with reference to the drawings. FIG. 1 is a plan view of a substrate processing apparatus 1 according to the first embodiment. FIG. 2 is a longitudinal sectional view illustrating a plurality of (for example, three) processing casings 9 and a liquid recovery layer 11.

In the present specification, for convenience, a direction in which an indexer block 2 and a processing block 3 are arranged is referred to as a "front-rear direction X". The front-rear direction X is horizontal. For example, a direction from the processing block 3 toward the indexer block 2 in the front-rear direction X is referred to as "front". A direction opposite to the front is referred to as "rear". A horizontal direction orthogonal to the front-rear direction X is referred to as a "width direction Y". One direction in the "width direction Y" is appropriately referred to as "right". A direction opposite to the right is referred to as "left". A direction perpendicular to the horizontal direction is referred to as a "vertical direction Z". In each drawing, front, rear, right, left, top, and bottom are appropriately indicated for reference. In the present specification, a "flow path" indicates a spatial region through which a fluid such as a gas or a liquid flows. In the present specification, a "pipe" indicates a tubular member in which a spatial region (that is, a flow path) in which a fluid such as a gas or a liquid flows is formed. In addition, in the present specification, when description is given with reference to a pipe, it may indicate a flow path in the pipe.

### <1. Overall configuration of substrate processing apparatus>

Reference is made to FIGS. 1 and 2. The substrate processing apparatus 1 processes a substrate W. The substrate processing apparatus 1 includes an indexer block 2 and a processing block 3.

The indexer block 2 includes a plurality of (for example, two) carrier placing tables 4 and a substrate conveyance robot IR. A carrier C for storing a plurality of (for example, 25) substrates W is placed on each of the two carrier placing tables 4. The substrate conveyance robot IR includes a hand 5 that holds the substrate W. The substrate conveyance robot IR can move the hand 5 in the front-rear direction X, the width direction Y, and the vertical direction Z, and rotate the hand 5 about a vertical axis. The substrate conveyance robot IR conveys the substrate W between the two carriers C on the two carrier placing tables 4 and a substrate placing table PS. Each of the substrate conveyance robot IR and a center robot CR (described later) is driven by an electric motor.

As illustrated in FIG. 1, the processing block 3 includes a conveyance space 7, a plurality of (for example, two) towers TW1 and TW2, the center robot CR, and the substrate placing table PS. The conveyance space 7 is formed to extend in the front-rear direction X in plan view. One end of the conveyance space 7 is adjacent to the indexer block 2. The two towers TW1 and TW2 are arranged in the width direction Y. The conveyance space 7 is disposed between the two towers TW1 and TW2. Both the two towers TW1 and TW2 are adjacent to the conveyance space 7.

As illustrated in FIG. 2, the tower TW1 includes a plurality of (for example, three) processing casings 9 and a liquid recovery layer (storage layer) 11. The plurality of (for example, three) processing casings 9 and the liquid recovery layer 11 are stacked in the vertical direction Z. The three processing casings 9 each process the substrates W one by one. The processing casing 9 is also referred to as a processing unit and a processing chamber.

Return to FIG. 1. The tower TW2 includes, for example, a plurality of heat treatment units 12. Each heat treatment unit 12 performs heat treatment on the substrate W. Each heat treatment unit 12 includes a plate 12A on which the substrate W is placed and a heater (not illustrated) that heats the plate 12A.

The center robot CR includes a hand 13 that holds the substrate W. The center robot CR can move the hand 13 in the front-rear direction X, the width direction Y, and the vertical direction Z, and rotate the hand 13 about the vertical axis. The center robot CR conveys the substrate W among the three processing casings 9, the plurality of heat treatment units 12, and the substrate placing table PS.

The substrate placing table PS is disposed between the substrate conveyance robot IR and the center robot CR. The substrate placing table PS is configured to be able to place at least one substrate W. As a result, the substrate W conveyed from one of the substrate conveyance robot IR and the center robot CR can be temporarily placed and delivered to the other.

The substrate processing apparatus 1 includes a controller 15 and a storage medium (not illustrated). The controller 15 controls each component of the substrate processing apparatus 1. The controller 15 includes one or more processors such as a central processing unit (CPU). The storage medium (memory) includes, for example, at least one of a read-only memory (ROM), a random-access memory (RAM), and a hard disk. The storage medium stores a computer program necessary for controlling each component of the substrate processing apparatus 1.

### <2. Processing casing and liquid recovery layer>

Reference is made to FIG. 2. As described above, the tower TW1 includes, for example, three processing casings 9. The three processing casings 9 are distinguished as a processing casing 9A, a processing casing 9B, and a processing casing 9C. When the processing casings 9A, 9B, and 9C are not distinguished from one another, they are each referred to as "processing casing 9".

The liquid recovery layer 11, the processing casing 9A, the processing casing 9B, and the processing casing 9C are arranged in this order in an upward direction. Specific description will be given. The processing casing 9A is disposed on an upper portion (upper side) of the liquid recovery layer 11. The processing casing 9B is disposed on an upper portion of the processing casing 9A. The processing casing 9C is disposed on an upper portion of the processing casing 9B. The processing casing 9C is at the highest position among the three processing casings 9A to 9C. In other words, the processing casing 9C is located in the uppermost layer.

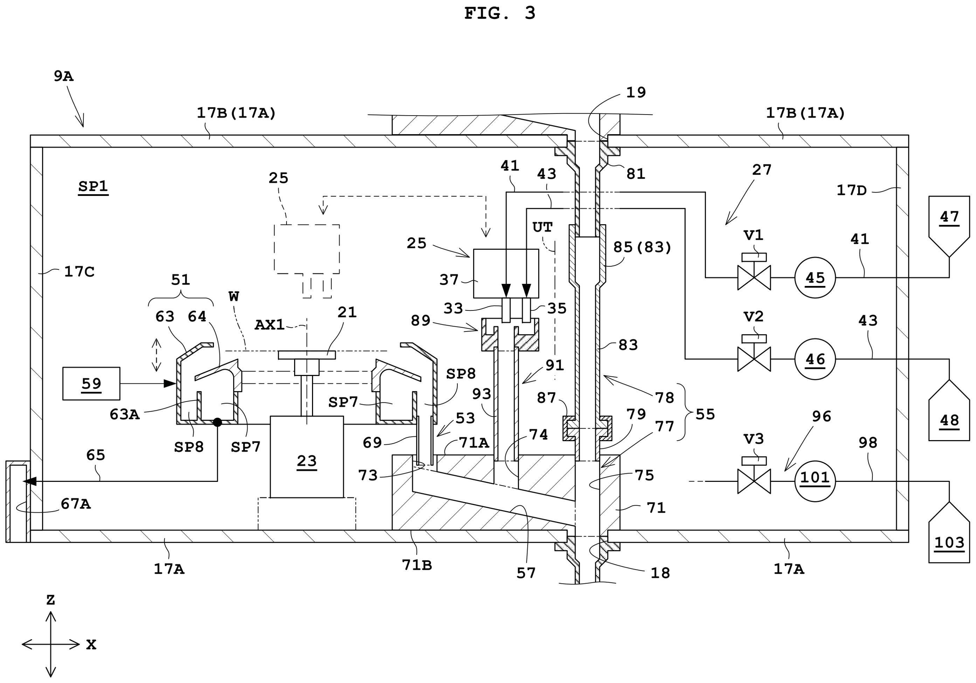

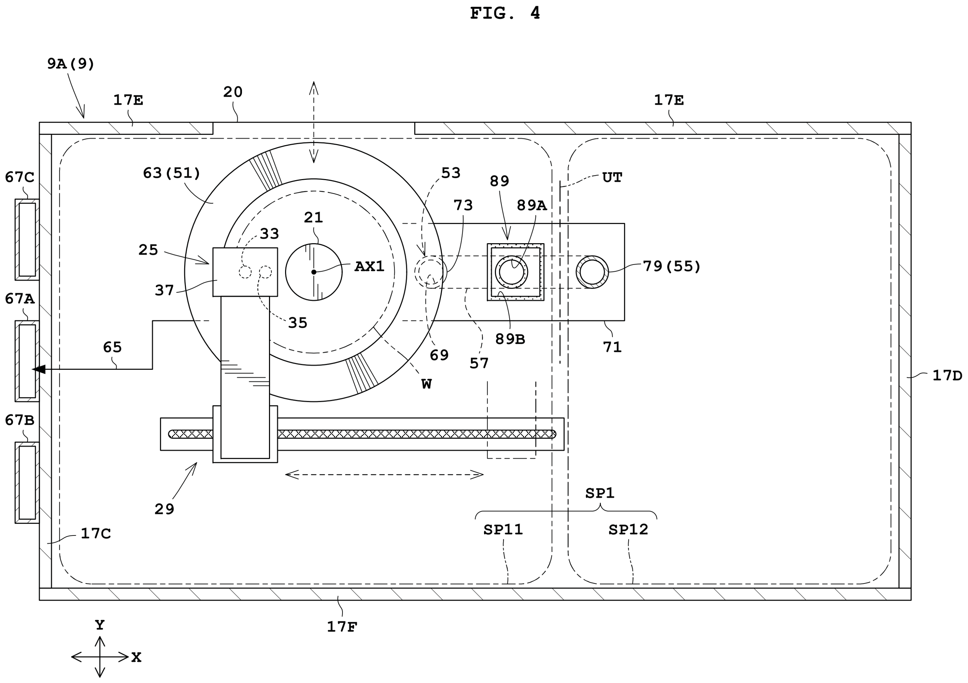

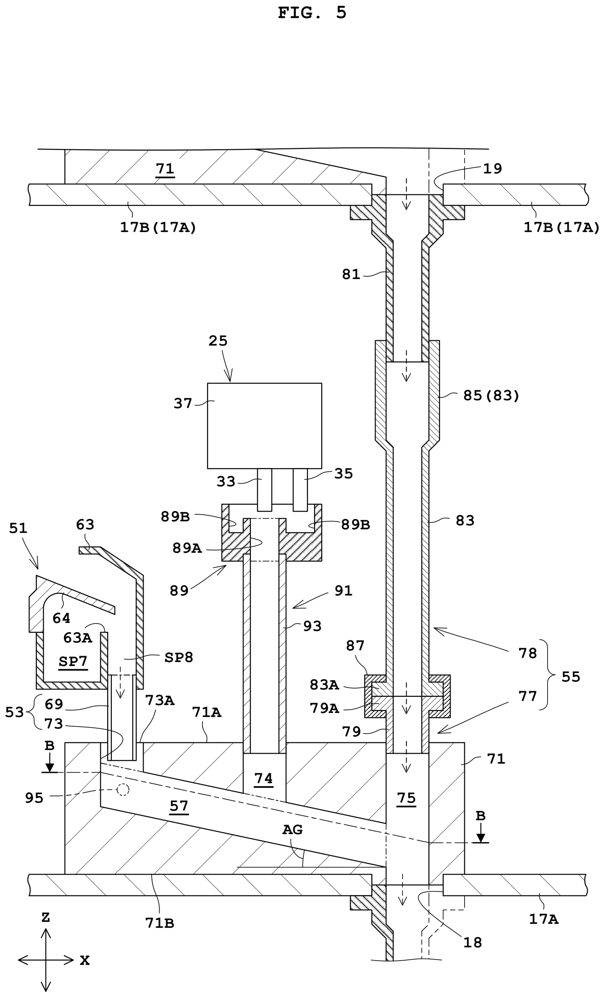

The two processing casings 9A and 9B have the same configuration. In addition, the processing casing 9C has the same configuration as each of the processing casings 9A and 9B except for an upper drainage flow path 78, for example. Therefore, a detailed configuration of the processing casing 9 will be described using the processing casing 9A as an example. FIG. 3 is a longitudinal sectional view of the processing casing 9A that is not in the uppermost layer. FIG. 4 is a transverse sectional view of the processing casing 9A that is not in the uppermost layer. FIG. 5 is a longitudinal sectional view illustrating a drainage structure of the processing casing 9A that is not in the uppermost layer.

Reference is made to FIGS. 3 and 4. First, the processing casing 9A includes an internal space SP1, a bottom wall 17A, a ceiling wall 17B, and four side walls 17C, 17D, 17E, and 17F. The internal space SP1 is a space inside the processing casing 9A. The internal space SP1 is a space surrounded by the bottom wall 17A, the ceiling wall 17B, and the four side walls 17C, 17D, 17E, and 17F.

The bottom wall 17A defines a lower surface of the internal space SP1. The bottom wall 17A has a bottom hole 18 penetrating the bottom wall 17A. The ceiling wall 17B defines an upper surface of the internal space SP1. The ceiling wall 17B has a ceiling hole 19 penetrating the ceiling wall 17B. The four side walls 17C to 17F define four side surfaces of the internal space SP1. The ceiling hole 19 overlaps a part or all of the bottom hole 18 in plan view.

In FIG. 3, the ceiling wall 17B is the bottom wall 17A of the processing casing 9B one layer above. In other words, the ceiling wall 17B of the processing casing 9A and the bottom wall 17A of the processing casing 9B are one common member. In this regard, the ceiling wall 17B of the processing casing 9A may be provided separately from the bottom wall 17A of the processing casing 9B.

The two side walls 17C and 17D are disposed in the front-rear direction X. The side wall 17C and the side wall 17D face each other with a spin chuck 21 (described later) interposed therebetween. As illustrated in FIG. 4, the two side walls 17E and 17F are arranged in the width direction Y. The two side walls 17E and 17F face each other with the spin chuck 21 interposed therebetween. The side wall 17E is a side wall on the conveyance space 7 side (see FIG. 1). In addition, the side wall 17E includes a carry-in port 20 for carrying in and out the substrate. The carry-in port 20 can be opened and closed by a shutter (not illustrated). The side wall 17F is a side wall for maintenance and is detachable from the processing casing 9A.

The processing casing 9A includes the spin chuck 21, a rotation drive unit 23, an ejection unit 25, a liquid supply unit 27, and a nozzle moving unit 29 in the internal space SP1. The spin chuck 21 holds the one substrate W in a horizontal posture. The spin chuck 21 holds the substrate W by, for example, vacuum-sucking the substrate W. For example, one or more holes are provided on an upper surface of the spin chuck 21. A pump (not illustrated) is configured to suck a gas from the one or more suction holes. The spin chuck 21 may hold the substrate W by gripping a side surface of the substrate W with three or more holding pins arranged around a vertical axis AX1. The rotation drive unit 23 includes, for example, an electric motor. The rotation drive unit 23 rotates the spin chuck 21 about the vertical axis AX1. The vertical axis AX1 passes through the center of the substrate W held by the spin chuck 21.

As illustrated in FIG. 3, the ejection unit 25 includes a coating liquid nozzle 33, a solvent nozzle 35, and a nozzle holding member 37. The coating liquid nozzle 33 and the solvent nozzle 35 are attached to the nozzle holding member 37. Therefore, the coating liquid nozzle 33, the solvent nozzle 35, and the nozzle holding member 37 are integrally moved.

The coating liquid nozzle 33 (the ejection unit 25) ejects a coating liquid to an upper surface of the substrate W held by the spin chuck 21. The coating liquid is a liquid for forming a film on the upper surface of the substrate W. As the coating liquid, for example, a resist liquid is used. A viscosity of the coating liquid (for example, the resist liquid) is, for example, 500 to 20000 centipoise (cP). Similarly, the solvent nozzle 35 (the ejection unit 25) ejects a solvent to the upper surface of the substrate W held by the spin chuck 21. As the solvent, for example, an organic solvent is used. Specifically, as the organic solvent, for example, N-methyl-2-pyrrolidone (NMP) or cyclopentanone is used.

The liquid supply unit 27 includes a coating liquid pipe 41, a solvent pipe 43, two on-off valves V1 and V2, and two pumps 45 and 46. One end of the coating liquid pipe 41 is connected to the coating liquid nozzle 33. The other end of the coating liquid pipe 41 is connected to a coating liquid supply source 47. The on-off valve V1 and the pump 45 are provided in the coating liquid pipe 41. The pump 45 feeds the coating liquid of the coating liquid supply source 47 to the coating liquid nozzle 33 through the coating liquid pipe 41. The on-off valve V1 selectively supplies the coating liquid and stops the supply of the coating liquid.

Similarly, one end of the solvent pipe 43 is connected to the solvent nozzle 35. The other end of the solvent pipe 43 is connected to a solvent supply source 48. The on-off valve V2 and the pump 46 are provided in the solvent pipe 43. The pump 46 feeds the solvent of the solvent supply source 48 to the solvent nozzle 35 through the solvent pipe 43. The on-off valve V2 selectively supplies the solvent and stops the supply of the solvent. Note that the coating liquid supply source 47 and the solvent supply source 48 are provided outside the processing casing 9. Further, the supply pump 46 may be provided in a cabinet individually installed outside the processing casing 9.

The nozzle moving unit 29 illustrated in FIG. 4 moves the ejection unit 25 (the coating liquid nozzle 33, the solvent nozzle 35, and the like) in the front-rear direction X and the vertical direction Z. As a result, the nozzle moving unit 29 can move the ejection unit 25 between an arbitrary position above the substrate W held by the spin chuck 21 and a standby pot 89 (described later). The nozzle moving unit 29 includes, for example, a plurality of (for example, two) electric motors that move the ejection unit 25 in the front-rear direction X and the vertical direction Z. The nozzle moving unit 29 may be configured to be able to move the ejection unit 25 in the front-rear direction X, the width direction Y, and the vertical direction Z.

### <2-1. Cup and drainage structure>

First, an outline of a cup 51 and a drainage structure will be described with reference to FIG. 2. The processing casing 9 includes, in the internal space SP1, the cup 51, a cup drainage flow path 53 that is formed to extend vertically downward from the cup 51 and discharges the coating liquid received by the cup 51, a casing drainage flow path 55 formed to extend in the vertical direction Z, and a connection flow path 57 that connects a lower end of the cup drainage flow path 53 and the casing drainage flow path 55. As illustrated in FIG. 2, the respective casing drainage flow paths 55 (three casing drainage flow paths 55) of the three processing casings 9A to 9C are linearly connected as the three processing casings 9A to 9C are stacked in the vertical direction Z. That is, the three casing drainage flow paths 55 form one flow path extending in the vertical direction Z.

Next, these will be described in detail with reference to FIG. 3. The cup 51 and the spin chuck 21 are disposed closer to the side wall 17C than the side wall 17D. The cup 51 includes an outer cup 63 and an inner cup 64. The inner cup 64 is formed to surround an outer peripheral edge of the spin chuck 21. The outer cup 63 is formed to surround an outer peripheral edge of the inner cup 64.

The processing casing 9A includes a cup lift unit 59 in the internal space SP1 in addition to the cup 51. The cup lift unit 59 includes an air cylinder or an electric actuator. The electric actuator includes an electric motor. The cup lift unit 59 moves the cup 51 in the vertical direction Z.

Specifically, the cup lift unit 59 moves the cup 51 between a processing position and a lower position located below the processing position. As the cup 51 moves to the processing position, an upper end of the cup 51 is positioned at a position higher than the substrate W held by the spin chuck 21. As a result, the cup 51 can receive the coating liquid ejected to the upper surface of the substrate W and scattered around. In FIG. 3, the cup 51 is located at the processing position.

In an inside of the outer cup 63, a space SP8 outside a partition wall 63A is a space for collecting the coating liquid. The inner cup 64 is provided inside the outer cup 63. The inner cup 64 guides the coating liquid received on an upper surface of the inner cup 64 to the space SP8. A drainage pipe 69 is attached to a bottom wall (or a lower portion) of the outer cup 63 in the space SP8. The drainage pipe 69 extends in the vertical direction Z. The drainage pipe 69 discharges the coating liquid received by the cup 51 to an outside of the cup 51.

The cylindrical partition wall 63A is provided on the bottom wall of the outer cup 63. In the inside of the outer cup 63, a space SP7 inside the partition wall 63A is a space for collecting a gas to be exhausted. One end of an exhaust pipe 65 is connected to the bottom wall of the outer cup 63 in the space SP7. The other end of the exhaust pipe 65 passes through the side wall 17C and is connected to an external exhaust pipe 67A provided outside the processing casing 9A. The external exhaust pipe 67A is provided on an outer surface of the side wall 17C.

As illustrated in FIG. 4, on the outer surface of the side wall 17C of the processing casing 9A, two external exhaust pipes 67B and 67C for discharging the gas having been exhausted from the processing casings 9B and 9C disposed above the processing casing 9A, to the outside of the substrate processing apparatus 1, are provided. A distal end (lower end) of each of the three external exhaust pipes 67A, 67B, and 67C is connected to an exhaust facility of a factory. In FIG. 4, the three external exhaust pipes 67A, 67B, and 67C cause the gas to flow downward. Note that the two external exhaust pipes 67B and 67C are provided on the outer surface of the processing casing 9B, and the one external exhaust pipe 67C is provided on the outer surface of the processing casing 9C.

Reference is made to FIG. 5. The processing casing 9A includes a base member 71 in the internal space SP1. The base member 71 is attached to an upper surface of the bottom wall 17A by, for example, at least one of a screw and a bolt. The base member 71 includes a cup-side flow path 73, a pot-side flow path 74, a lower flow path 75, and the connection flow path 57. Specifically, each of the flow paths (the cup-side flow path 73, pot-side flow path 74, lower flow path 75, and connection flow path 57) is formed by processing the base member 71 and forming a hole.

The cup drainage flow path 53 described above is formed by a flow path in the drainage pipe 69 and the cup-side flow path 73. The cup-side flow path 73 is formed to extend vertically downward from an upper surface 71A of the base member 71. Further, the cup-side flow path 73 does not reach a lower surface 71B of the base member 71. A lower end of the drainage pipe 69 is inserted into an inlet 73A at an upper end of the cup-side flow path 73. A distal end of the drainage pipe 69 moves in the cup-side flow path 73 by lifting and lowering of the cup 51. Note that an inner diameter of the cup-side flow path 73 is larger than an outer diameter of the drainage pipe 69 so as not to hinder the lifting and lowering of the cup 51. The drainage pipe 69 and the cup-side flow path 73 are linearly arranged.

The above described casing drainage flow path 55 is formed on an opposite side of the side wall 17C with the cup 51 interposed therebetween. The casing drainage flow path 55 is formed by a lower drainage flow path 77 and an upper drainage flow path 78. When the base member 71 is attached to a preset position of the bottom wall 17A, the lower flow path 75 (the lower drainage flow path 77) is attached to the bottom hole 18 of the bottom wall 17A. The bottom hole 18 is closed by the base member 71. The lower drainage flow path 77 is formed to extend vertically upward from the bottom hole 18. A length of the lower drainage flow path 77 is, for example, about 1/3 of a length of the casing drainage flow path 55 or a length of the internal space SP1 in the vertical direction Z.

The lower drainage flow path 77 is formed by the lower flow path 75 and a flow path in a flanged pipe 79. The lower flow path 75 penetrates between the upper surface 71A and the lower surface 71B of the base member 71. A lower end of the lower flow path 75 is disposed in the bottom hole 18. The flanged pipe 79 is coupled to the upper end of the lower flow path 75. A flange 79A is provided at an upper end of the flanged pipe 79. The lower flow path 75 and the flanged pipe 79 are linearly coupled. The lower flow path 75 and the flanged pipe 79 each extend in the vertical direction Z.

The upper drainage flow path 78 is connected to the lower end of the casing drainage flow path 55 of the processing casing 9B one layer above. The upper drainage flow path 78 is detachably attached to the ceiling hole 19 of the ceiling wall 17B (the bottom hole 18 of the bottom wall 17A of the processing casing 9B one layer above). The upper drainage flow path 78 is formed to extend vertically downward from the ceiling hole 19. The upper drainage flow path 78 can expand and contract. When the upper drainage flow path 78 is attached to the processing casing 9A, a length of the upper drainage flow path 78 is, for example, about 2/3 of a length of the casing drainage flow path 55 or a length of the internal space SP1 in the vertical direction Z.

The upper drainage flow path 78 is formed by a flow path in an upper pipe 81 and a flow path in a flanged pipe 83. The upper pipe 81 is attached to a lower surface of the ceiling wall 17B by, for example, at least one of a screw and a bolt. An upper end of the upper pipe 81 is disposed in the ceiling hole 19. The ceiling hole 19 is closed by the upper pipe 81. An accommodating portion 85 formed to accommodate a lower portion of the upper pipe 81 is provided on an upper portion of the flanged pipe 83. As a result, the flanged pipe 83 can move in the vertical direction Z with respect to the upper pipe 81. That is, the upper drainage flow path 78 (the upper pipe 81 and the flanged pipe 83) can expand and contract.

An inner diameter of the accommodating portion 85 is larger than an outer diameter of the lower portion of the upper pipe 81. An O-ring is disposed between the accommodating portion 85 and the lower portion of the upper pipe 81. As a result, a gap between the accommodating portion 85 and the lower portion of the upper pipe 81 is closed. A flange 83A is provided at a lower end of the flanged pipe 83. The upper pipe 81 and the flanged pipe 83 are linearly coupled. The upper pipe 81 and the flanged pipe 83 each extend in the vertical direction Z.

The accommodating portion 85 may be provided in the lower portion of the upper pipe 81 instead of the upper portion of the flanged pipe 83. In this case, the accommodating portion at the lower portion of the upper pipe 81 accommodates the upper portion of the flanged pipe 83.

An upper end of the lower drainage flow path 77 is separably coupled to a lower end of the upper drainage flow path 78 by a coupling member 87. The coupling member 87 couples the two flanges 79A and 83A. The coupling member 87 may be a ring-shaped member having a C-shaped cross section formed to sandwich the two flanges 79A and 83A in the vertical direction Z at two ends of the C-shape. The coupling member 87 may be at least one of a screw, a bolt, and a clamp.

The drainage pipe 69, the base member 71(the cup-side flow path 73, pot-side flow path 74, lower flow path 75, and connection flow path 57), the flanged pipe 79, the upper pipe 81, and the flanged pipe 83 are each formed of, for example, fluororesin or stainless steel. As the fluororesin, for example, perfluoroalkoxy alkane (PFA) or polytetrafluoroethylene (PTFE) is used.

According to the configuration of the present embodiment, in each of the processing casings 9A, 9B, and 9C, the lower drainage flow path 77 and the upper drainage flow path 78 extend in the vertical direction Z. The upper drainage flow path 78 of the processing casing 9A is connected to a lower end of the lower drainage flow path 77 of the casing drainage flow path 55 of the processing casing 9B one layer above. Also in the processing casing 9B, the upper drainage flow path 78 of the processing casing 9B is connected to the lower end of the lower drainage flow path 77 of the casing drainage flow path 55 of the processing casing 9C one layer above. At this time, at least a part of the casing drainage flow path 55 of each of the processing casings 9A, 9B, and 9C overlaps in plan view. In other words, for example, the three casing drainage flow paths 55 at least partially overlap each other. In other words, the lower drainage flow path 77 and the upper drainage flow path 78 of each of the processing casings at least partially overlap in plan view.

Most preferably, the processing casings 9A, 9B, and 9C are provided such that the centers of the casing drainage flow paths 55 of the processing casings 9A, 9B, and 9C coincide with each other in plan view. By connecting the respective casing drainage flow paths 55 extending in the processing casings 9A, 9B, and 9C, in the vertical direction Z, the casing drainage flow paths 55 do not need to bypass the processing casings 9A, 9B, and 9C. Therefore, it is possible to facilitate the flow of the coating liquid while shortening each casing drainage flow path 55. Thus, the coating liquid can be efficiently recovered.

Reference is made to FIG. 5. The connection flow path 57 connects the lower end of the cup drainage flow path 53 and the casing drainage flow path 55. Specifically, one end of the connection flow path 57 is connected to a lower end of the cup-side flow path 73. The other end of the connection flow path 57 is connected to the lower flow path 75 at a lower end portion of the lower flow path 75. This makes it easy to secure an inclination of the connection flow path 57. The connection flow path 57 is formed to be inclined downward and in a direction toward the casing drainage flow path 55. The connection flow path 57 is formed to extend linearly.

When the connection flow path 57 (the base member 71) is formed of fluororesin, an angle AG (absolute value) between the connection flow path 57 and the horizontal direction is, for example, 15 degrees. Furthermore, the angle AG (absolute value) is preferably, for example, 5 degrees or more and less than 90 degrees.

When the connection flow path 57 extends in the horizontal direction, it is particularly difficult to cause a coating liquid having a high viscosity to flow. In addition, for example, when the casing drainage flow path 55 is provided outside the processing casing 9A, the connection flow path 57 becomes long, and it is difficult to secure the inclination of the connection flow path 57. Therefore, the coating liquid hardly flows, and it becomes difficult to recover the coating liquid. On the other hand, in the present embodiment, since the casing drainage flow path 55 is provided in the internal space SP1 of the processing casing 9A, and the cup drainage flow path 53 and the casing drainage flow path 55 are provided relatively close to each other, it is easy to secure the inclination of the connection flow path 57.

Reference is made to FIGS. 4 and 5. The processing casing 9A includes the standby pot 89 and a standby pot drainage flow path 91 in the internal space SP1. The standby pot 89 can cause the coating liquid nozzle 33 and the solvent nozzle 35 to stand by. The standby pot 89 is provided between the cup 51 and the casing drainage flow path 55 in plan view. The standby pot 89 can receive the coating liquid ejected from the coating liquid nozzle 33 and the solvent ejected from the solvent nozzle 35.

The standby pot 89 includes a main body 89A which is a container for receiving the coating liquid or the like, and a solvent storage portion 89B for storing a solvent. The solvent storage portion 89B is a ring groove formed in a ring shape along an outer peripheral edge of the main body 89A. The solvent storage portion 89B stores the solvent ejected from the solvent nozzle 35. As a result, the solvent in the solvent storage portion 89B is volatilized, and a distal end portion of the coating liquid nozzle 33 is wrapped in the solvent atmosphere, thereby suppressing drying of the coating liquid inside the distal end of the coating liquid nozzle 33.

The standby pot drainage flow path 91 discharges the coating liquid and the solvent received by the standby pot 89. The standby pot drainage flow path 91 is formed to extend vertically downward from the standby pot 89. The standby pot drainage flow path 91 is formed by a flow path in an intermediate pipe 93 and the pot-side flow path 74. The intermediate pipe 93 extends vertically downward from the main body 89A of the standby pot 89. The intermediate pipe 93 communicates with an inside of the main body 89A.

The pot-side flow path 74 is formed to extend vertically downward from the upper surface 71A of the base member 71. A lower end of the pot-side flow path 74 extends to the connection flow path 57. The intermediate pipe 93 is coupled to an upper end of the pot-side flow path 74. The intermediate pipe 93 and the pot-side flow path 74 are linearly arranged.

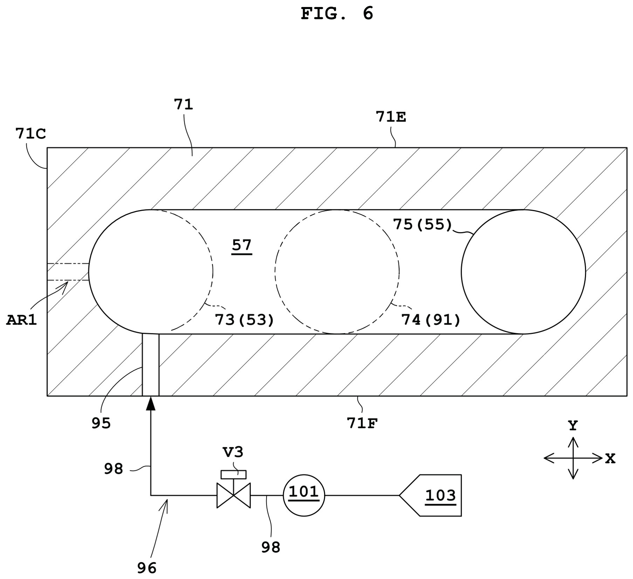

The standby pot drainage flow path 91 (the intermediate pipe 93 and the pot-side flow path 74) is connected to the connection flow path 57 between the cup drainage flow path 53 and the casing drainage flow path 55. In other words, the standby pot drainage flow path 91 is connected in the middle of the connection flow path 57 from the cup drainage flow path 53 toward the casing drainage flow path 55. In FIG. 5, a distance in the front-rear direction X between the cup drainage flow path 53 and the standby pot drainage flow path 91 is substantially the same as a distance in the front-rear direction X between the standby pot drainage flow path 91 and the casing drainage flow path 55. As illustrated in FIGS. 4 and 6, the cup drainage flow path 53, the standby pot drainage flow path 91, and the casing drainage flow path 55 are disposed on a straight line in plan view.

The intermediate pipe 93 is formed of, for example, fluororesin or stainless steel. More specifically, the fluororesin is perfluoroalkoxy alkane (PFA) or polytetrafluoroethylene (PTFE).

### <2-2. Ejection flow path and cleaning liquid supply unit>

As illustrated in FIGS. 3 and 6, the processing casing 9A includes an ejection flow path 95 and a cleaning liquid supply unit 96 in the internal space SP1. The ejection flow path 95 ejects the cleaning liquid (rinse liquid) to the connection flow path 57 in order to cause the coating liquid remaining in the connection flow path 57 and the casing drainage flow path 55 to flow. As the cleaning liquid, for example, an organic solvent is used.

The ejection flow path 95 is provided at a proximal end portion of the connection flow path 57 connected to the cup-side flow path 73 (the cup drainage flow path 53). The proximal end portion of the connection flow path 57 is a portion where the connection flow path 57 is connected to the cup-side flow path 73. Specifically, as illustrated in FIG. 6, the ejection flow path 95 is provided on a side surface 71F of the base member 71. In this regard, as indicated by an arrow AR1 in FIG. 6, the ejection flow path 95 may be provided on a side surface 71C of the base member 71. Further, the ejection flow path 95 may be provided on a side surface 71E of the base member 71. A distal end of the ejection flow path 95 is connected to the connection flow path 57.

The cleaning liquid supply unit 96 includes a cleaning liquid pipe 98, an on-off valve V3, and a pump 101. One end of the cleaning liquid pipe 98 is connected to the ejection flow path 95. The other end of the cleaning liquid pipe 98 is connected to a cleaning liquid supply source 103. The on-off valve V3 and the pump 101 are provided in the cleaning liquid pipe 98. The pump 101 feeds the cleaning liquid of the cleaning liquid supply source 103 to the ejection flow path 95 through the cleaning liquid pipe 98. The on-off valve V3 selectively supplies the cleaning liquid and stops the supply of the cleaning liquid. The cleaning liquid supply source 103 is provided outside the processing casing 9.

The connection flow path 57 is a flow path that connects the lower end of the cup drainage flow path 53 and the casing drainage flow path 55. According to the configuration of the present embodiment, since the ejection flow path 95 of the cleaning liquid supply unit 96 is provided at the proximal end portion of the connection flow path 57 to which the cup drainage flow path 53 is connected, the cleaning liquid can be ejected from the most upstream side in the connection flow path 57. Therefore, the cleaning liquid can be supplied to the entire connection flow path 57, enabling the coating liquid in the connection flow path 57 to suitably flow.

### <2-3. Internal space>

Reference is made to FIG. 4. The processing casing 9A may include an inner wall UT indicated by a two-dot chain line. In this case, the internal space SP1 includes a processing space SP11 closer to the side wall 17C than the inner wall UT, and a pipe space SP12 closer to the side wall 17D than the inner wall UT. The inner wall UT does not completely prevent the movement of gas between the processing space SP11 and the pipe space SP12. That is, the gas in the internal space SP1 is movable between the processing space SP11 and the pipe space SP12.

Reference is made to FIGS. 3 and 4. In the processing space SP11, the spin chuck 21, the rotation drive unit 23, the ejection unit 25 (the coating liquid nozzle 33 and the solvent nozzle 35), the nozzle moving unit 29, the cup 51, the cup drainage flow path 53, the exhaust pipe 65, the standby pot 89, and the standby pot drainage flow path 91 are arranged.

In the pipe space SP12, the casing drainage flow path 55, the on-off valves V1, V2, and V3, and the pumps 45, 46, and 101 are disposed. The base member 71 (the connection flow path 57), the coating liquid pipe 41, the solvent pipe 43, and the cleaning liquid pipe 98 are disposed so as to cross a boundary between the processing space SP11 and the pipe space SP12.

### <2-4. Processing casing of uppermost layer>

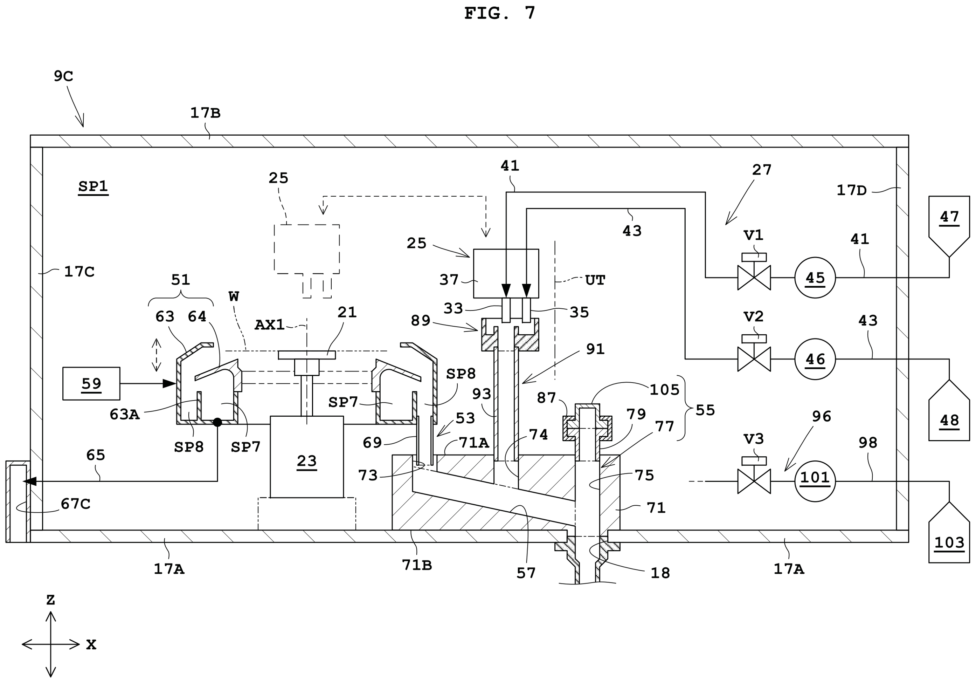

FIG. 7 is a longitudinal sectional view of the processing casing 9C of the uppermost layer. As described above, the processing casing 9C of the uppermost layer has substantially the same configuration as each of the processing casings 9A and 9B except for the upper drainage flow path 78, for example. Differences from the processing casings 9A and 9B, and peripheral structures thereof will be described.

The processing casing 9C includes the bottom wall 17A that determines the lower surface of the internal space SP1 of the processing casing 9C. The bottom wall 17A has the bottom hole 18. The casing drainage flow path 55 of the processing casing 9C includes the lower drainage flow path 77 and a lid member 105. The lower drainage flow path 77 is attached to the bottom hole 18. The lower drainage flow path 77 is formed to extend vertically upward from the bottom hole 18. The lid member 105 closes the upper end of the lower drainage flow path 77 (the flanged pipe 79). The coupling member 87 couples the lid member 105 and the flange 79A of the flanged pipe 79 of the lower drainage flow path 77. The ceiling wall 17B of the processing casing 9C is not formed with the ceiling hole 19. Note that the ceiling wall 17B of the processing casing 9C may be configured in the same manner as the ceiling walls 17B of the processing casings 9A and 9B, and the ceiling hole 19 of the ceiling wall 17B may be configured to be closed by a lid member.

### <2-5. Liquid recovery unit>

Reference is made to FIG. 2. The liquid recovery layer 11 includes the drainage pipe 107 and the liquid recovery tank 109. An upper end of the drainage pipe 107 is connected to a lower end (that is, a lower end of the lower flow path 75) of the casing drainage flow path 55 of the processing casing 9A one layer above. The drainage pipe 107 extends downward. The liquid recovery tank 109 stores the coating liquid and the cleaning liquid (solvent) discharged from the cup 51 and the standby pot 89 of each of the processing casings 9A to 9C. The liquid recovery tank 109 includes an inlet 109A in an upper portion thereof. A lower end of the drainage pipe 107 is connected to the inlet 109A.

The liquid recovery layer 11 may not include the liquid recovery tank 109. In this case, the lower end of the drainage pipe 107 may be connected to a drainage facility of a factory.

Each of the three processing casings 9A to 9C corresponds to a processing casing of the present invention. Each of the two processing casings 9A and 9B corresponds to a first processing casing of the present invention. The three processing casings 9A to 9C include two processing casings 9B and 9C. When the processing casing 9C corresponds to a second processing casing of the present invention, the processing casing 9B corresponds to a first processing casing of the present invention. The bottom wall 17A and the bottom hole 18 of each of the two processing casings 9A and 9B correspond to a first bottom wall and a first bottom hole of the present invention. The bottom wall 17A and the bottom hole 18 of the processing casing 9C correspond to a second bottom wall and a second bottom hole of the present invention.

The side wall 17C corresponds to a first side wall of the present invention. The side wall 17D corresponds to a second side wall of the present invention. The spin chuck 21 corresponds to a substrate holding unit or a chuck of the present invention. The coating liquid nozzle 33 corresponds to a processing liquid nozzle of the present invention. The ejection flow path 95 corresponds to a cleaning liquid ejection unit of the present invention.

According to the configuration of the present embodiment, the processing casings 9A to 9C have the same configuration except for the upper drainage flow path 78 of the processing casing 9C. In other words, the components constituting the processing casings 9A to 9C coincide with each other in plan view. Therefore, the apparatus can be easily assembled by stacking and arranging the processing casings 9A to 9C.

### <3. Substrate processing operation by substrate processing apparatus>

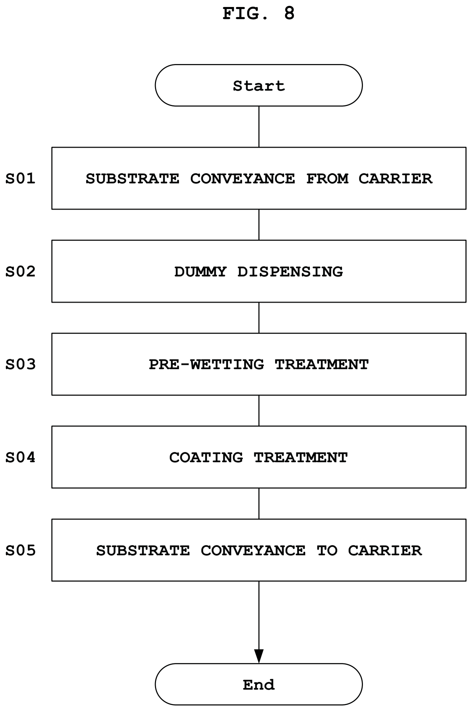

Next, an example of substrate processing operation by the substrate processing apparatus 1 will be described. FIG. 8 is a flowchart illustrating an example of the substrate processing operation by the substrate processing apparatus 1.

### [Step S01] Substrate conveyance from carrier

Reference is made to FIG. 1. The carrier C is placed on one of the two carrier placing tables 4. In the carrier C, 25 substrates W are stored. The substrate conveyance robot IR takes out the substrate W from the carrier C placed on the carrier placing table 4, and conveys the substrate W to the substrate placing table PS. The substrate conveyance robot IR sequentially conveys the remaining 24 substrates W from the carrier C to the substrate placing table PS.

The center robot CR receives the substrate W from the substrate placing table PS and conveys the substrate W to one of the three processing casings 9A to 9C. For example, the center robot CR conveys the substrate W to the processing casing 9A. At this time, the center robot CR conveys the substrate W to the upper surface of the spin chuck 21 through the carry-in port 20 of the side wall 17E. The spin chuck 21 holds the substrate W.

### [Step S02] Dummy dispensing

Reference is made to FIGS. 3 and 5. The coating liquid nozzle 33 and the solvent nozzle 35 are on standby at preset positions of the standby pot 89. For example, dummy dispensing is performed before ejecting the coating liquid to the substrate W. Specifically, by operating the on-off valve V1, the coating liquid is ejected from the coating liquid nozzle 33 to the main body 89A of the standby pot 89. The coating liquid flows through the main body 89A, the intermediate pipe 93, the pot-side flow path 74, the connection flow path 57, and the casing drainage flow path 55 (the lower flow path 75) in this order.

### [Step S03] Pre-wetting treatment

The nozzle moving unit 29 moves the ejection unit 25 from the standby pot 89 to above the substrate W held by the spin chuck 21 so that the solvent nozzle 35 is positioned at the center of the substrate W in plan view. Thereafter, by opening the on-off valve V2, the solvent is ejected from the solvent nozzle 35 to the upper surface of the substrate W. In addition, the rotation drive unit 23 rotates the spin chuck 21 holding the substrate W about the vertical axis AX1. As a result, the solvent on the upper surface of the substrate W is spread over the entire upper surface of the substrate W. That is, the pre-wetting treatment in which the solvent is supplied to the substrate W prior to the coating liquid is performed.

The solvent scattered from the rotated substrate W is recovered by the cup 51. The solvent recovered by the cup 51 flows through the drainage pipe 69, the cup-side flow path 73, the connection flow path 57, and the casing drainage flow path 55 (the lower flow path 75) in this order.

After a preset amount of solvent is ejected from the solvent nozzle 35, the on-off valve V2 is closed to stop the ejection of the solvent from the solvent nozzle 35. Further, the nozzle moving unit 29 moves the ejection unit 25 so that the coating liquid nozzle 33 is positioned at the center of the substrate W in plan view.

### [Step S04] Coating treatment

Thereafter, by operating the on-off valve V1, a preset amount of coating liquid is ejected from the coating liquid nozzle 33 to a liquid film of the solvent on the upper surface of the substrate W. In addition, the rotation drive unit 23 rotates the spin chuck 21 holding the substrate W about the vertical axis AX1. As a result, the coating liquid is spread over the entire upper surface of the substrate W while the liquid film of the solvent on the upper surface of the substrate W is replaced with the coating liquid. That is, the coating treatment is performed on the substrate W.

The coating liquid scattered from the rotated substrate W is recovered by the cup 51. As in the case of the solvent, the coating liquid recovered by the cup 51 flows through the drainage pipe 69, the cup-side flow path 73, the connection flow path 57, and the casing drainage flow path 55 (the lower flow path 75) in this order.

After the coating treatment, a back-rinsing treatment for cleaning a lower surface of the substrate W may be performed. The back-rinsing treatment is performed by ejecting a solvent from a nozzle (not illustrated) to the lower surface of the substrate W held by the spin chuck 21 while rotating the substrate.

### [Step S05] Substrate conveyance to carrier

Reference is made to FIG. 1. Thereafter, the rotation drive unit 23 stops the rotation of the spin chuck 21. Thereafter, the spin chuck 21 releases the holding of the substrate W. Thereafter, the center robot CR receives the substrate coated with the coating liquid from the spin chuck 21 through the carry-in port 20. The center robot CR conveys the substrate W to the heat treatment unit 12. The heat treatment unit 12 performs a baking treatment on the substrate W coated with the coating liquid.

Thereafter, the center robot CR conveys the substrate W having been subjected to the baking treatment, from the heat treatment unit 12 to the substrate placing table PS. Thereafter, the substrate conveyance robot IR conveys the substrate W having been subjected to the baking treatment, from the substrate placing table PS to the carrier C placed on the carrier placing table 4. After the 25 substrates W having been subjected to the baking treatment are conveyed to the carrier C, the carrier C is conveyed from the carrier placing table 4 to the next destination.

### <4. Three paths of cleaning liquid to casing drainage flow path>

Three supply paths of the cleaning liquid (solvent) to the casing drainage flow path 55 and the like will be described. The cleaning liquid is supplied to the connection flow path 57, the casing drainage flow path 55, and the like through the three paths to thereby cause the coating liquid to be in a wet state, and the coating liquid is drained. In addition, when a resist liquid having a high viscosity is used as the coating liquid, there are the following findings.

If the resist liquid having the high viscosity remains in the middle of the drainage flow path and is dried, the resist is cured on the drainage flow path and is not suitably drained. As a result, for example, there is a possibility that the drainage flow path is blocked. Therefore, the solvent is supplied to the drainage flow path. However, even when the solvent is supplied, an effect of causing the resist liquid having the high viscosity to flow in a short time is hardly expected. Therefore, for example, the solvent is periodically replenished. This enables the resist liquid having the high viscosity to keep a liquid state without drying out. As a result, the resist liquid having the high viscosity flows slowly over time.

### <4-1. First path>

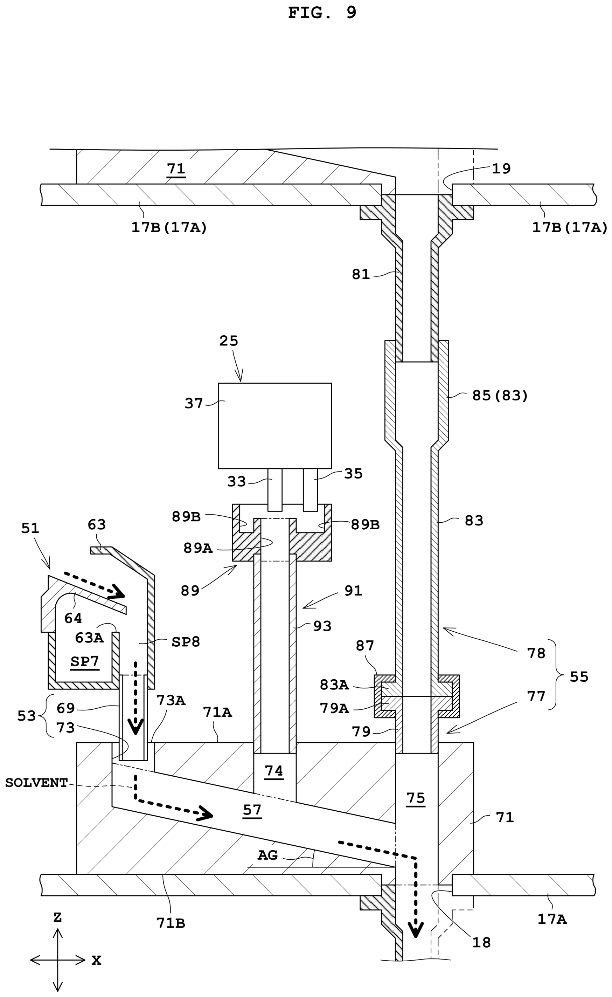

Reference is made to FIG. 9. A first path is a path through which the cleaning liquid flows from the cup 51 to the casing drainage flow path 55. In step S03, the solvent is ejected from the solvent nozzle 35 to the rotated substrate W. In step S04, the back-rinsing treatment for ejecting the solvent from the nozzle (not illustrated) to the lower surface of the rotated substrate W is performed. In a cup cleaning processing, a solvent may be supplied from a shower ring (cup cleaning member) (not illustrated) to the cup 51.

Then, the solvent scattered from the rotated substrate W or the like is recovered by the cup 51. As shown in FIG. 9, the solvent recovered by the cup 51 flows through the drainage pipe 69, the cup-side flow path 73, the connection flow path 57, and the casing drainage flow path 55 (the lower flow path 75) in this order.

In FIG. 2, the solvent recovered by the cup 51 of the processing casing 9C of the uppermost layer flows through the casing drainage flow path 55 of the processing casing 9C, the casing drainage flow path 55 of the processing casing 9B, the casing drainage flow path 55 of the processing casing 9A, the drainage pipe 107, and the liquid recovery tank 109 in this order. In addition, the solvent recovered by the cup 51 of the processing casing 9B flows through the casing drainage flow path 55 of the processing casing 9B, the casing drainage flow path 55 of the processing casing 9A, the drainage pipe 107, and the liquid recovery tank 109 in this order.

### <4-2. Second path>

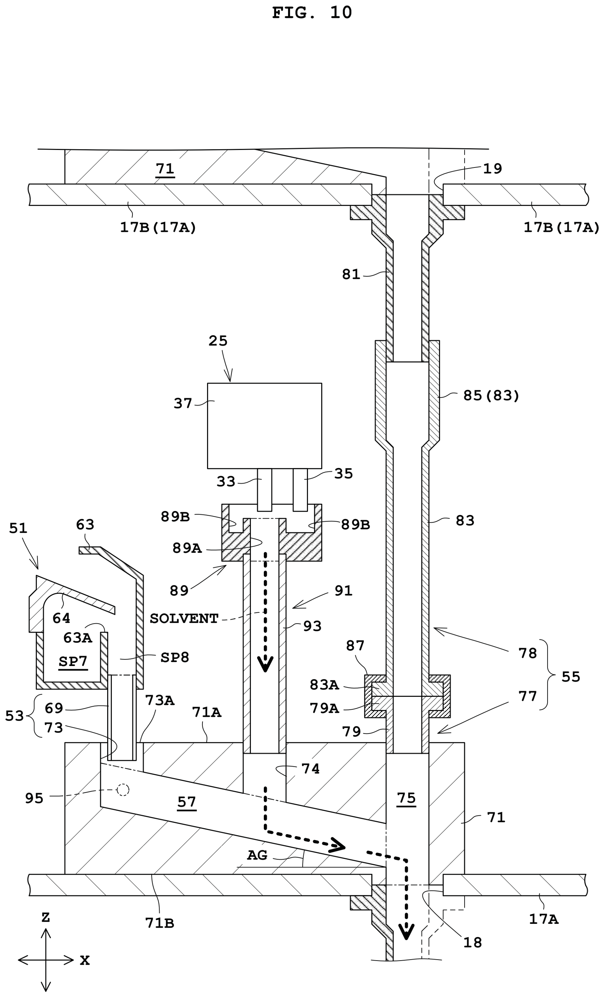

Reference is made to FIG. 10. A second path is a path through which the cleaning liquid flows from the standby pot 89 to the casing drainage flow path 55. It is assumed that the ejection unit 25 is located at a standby position of the standby pot 89. By operating the on-off valve V2 at an arbitrary timing, the solvent is ejected from the solvent nozzle 35 to the solvent storage portion 89B of the standby pot 89. The ejected solvent is stored in the solvent storage portion 89B. In addition, the excessive solvent overflows from the solvent storage portion 89B to the main body 89A. As shown in FIG. 10, the solvent having overflowed flows through the main body 89A, the intermediate pipe 93, the pot-side flow path 74, the connection flow path 57, and the casing drainage flow path 55 (the lower flow path 75) in this order.

### <4-3. Third path>

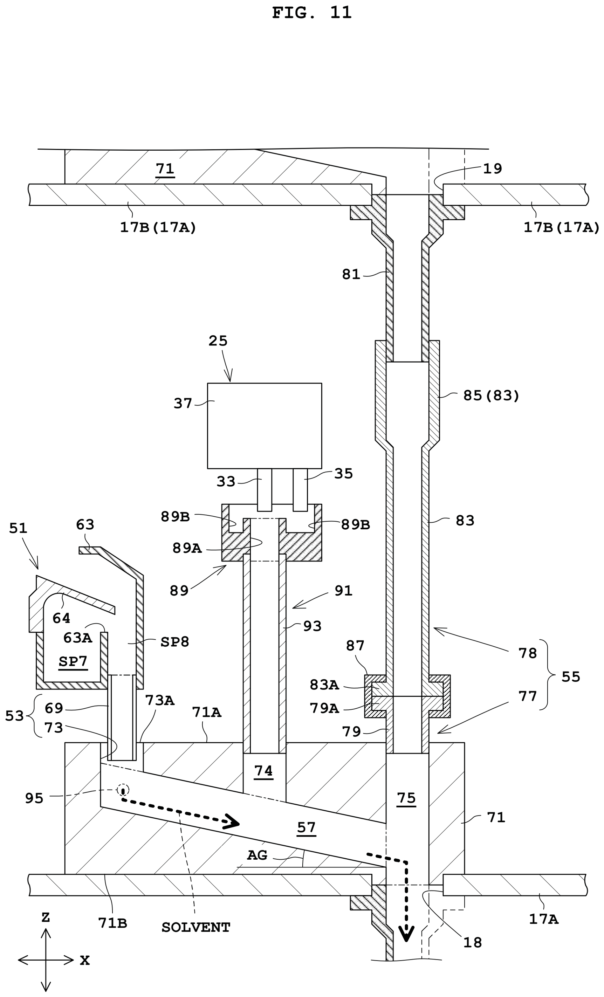

Reference is made to FIG. 11. A third path is a path through which the cleaning liquid flows from the ejection flow path 95 to the casing drainage flow path 55. By operating the on-off valve V3, the cleaning liquid is ejected from the ejection flow path 95 to the connection flow path 57. The cleaning liquid is ejected at an arbitrary timing. For example, it is preferable that the cleaning liquid is periodically ejected from the ejection flow path 95. The ejected cleaning liquid is caused to flow through the connection flow path 57 and the casing drainage flow path 55 (the lower flow path 75) in this order.

The ejection flow path 95 is provided upstream of a lower end of the standby pot drainage flow path 91 (the pot-side flow path 74) extending from the standby pot 89 in the connection flow path 57. Therefore, the ejection flow path 95 can eject the cleaning liquid to a portion where the coating liquid starts to enter the connection flow path 57. Therefore, the coating liquid remaining in the middle of the connection flow path 57 can flow from the further upstream side. In addition, the timing of supplying the cleaning liquid from the cup 51 to the connection flow path 57 depends on, for example, the timing of the pre-wetting treatment. Therefore, the ejection flow path 95 can eject the cleaning liquid regardless of the timing of the pre-wetting treatment. In other words, the cleaning liquid can be ejected from the ejection flow path 95 to the proximal end portion of the connection flow path 57 to which the cup drainage flow path 53 is connected, for example, at an arbitrary timing other than the timing of the pre-wetting treatment or the like.

### <5. Maintenance method>

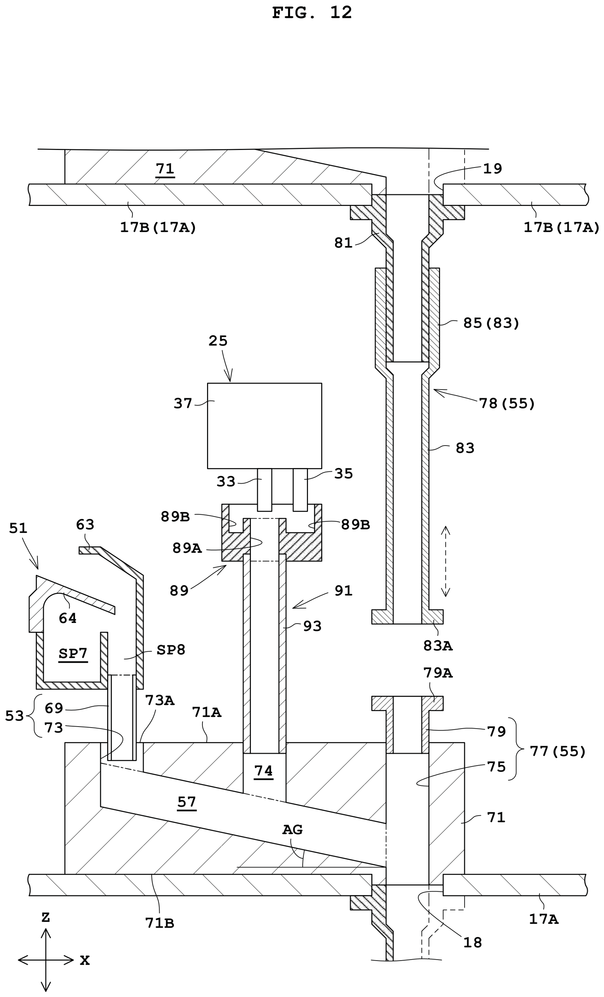

Next, a maintenance method, in particular, a method of detaching the casing drainage flow path 55 will be described. FIG. 12 is a diagram for describing the maintenance method of the substrate processing apparatus 1.

As illustrated in FIG. 5, the coupling member 87 couples the two flanges 79A and 83A. Therefore, the coupling member 87 is removed from the two flanges 79A and 83A. As a result, the lower drainage flow path 77 and the upper drainage flow path 78 of the casing drainage flow path 55 can be separated.

Reference is made to FIG. 12. The upper drainage flow path 78 can expand and contract. Specifically, in the upper drainage flow path 78, the accommodating portion 85 formed in the upper portion of the flanged pipe 83 accommodates the lower portion of the upper pipe 81. Therefore, the flanged pipe 83 can be lifted and lowered with respect to the upper pipe 81.

Thereafter, the upper pipe 81 is detached from the ceiling wall 17B. Since the upper drainage flow path 78 can expand and contract, a sufficient gap can be secured between the lower drainage flow path 77 and the upper drainage flow path 78. Therefore, the upper pipe 81 can be easily detached from the ceiling wall 17B. Thereafter, the upper pipe 81 and the flanged pipe 83 are separated. Further, the base member 71 is detached from the bottom wall 17A.

Thereafter, the upper pipe 81, the flanged pipe 83, the base member 71, and the like are individually cleaned. After the cleaning, the upper pipe 81, the flanged pipe 83, the base member 71, and the like are attached to the processing casing 9 by a reverse procedure of the above described procedure.

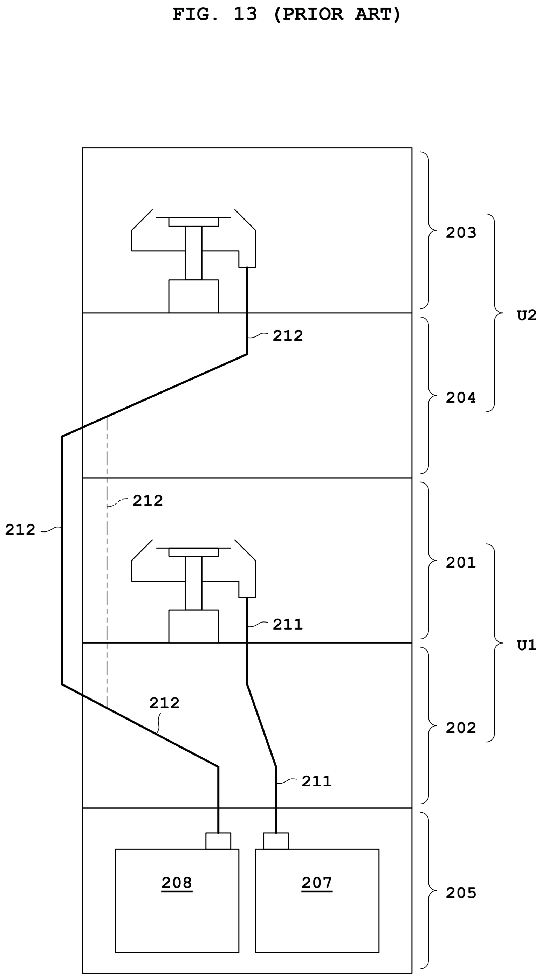

Next, effects of the present embodiment will be described. FIG. 13 is a longitudinal sectional view illustrating two processing units U1 and U2 stacked in the vertical direction of a conventional substrate processing apparatus as a comparative example.

Reference is made to FIG. 13. The lower processing unit U1 includes a first processing main body 201 and a first liquid recovery unit 202. The upper processing unit U2 includes a second processing main body 203 and a second liquid recovery unit 204. A liquid recovery layer 205 is disposed below the two processing units U1 and U2. The liquid recovery layer 205 includes two liquid recovery tanks 207 and 208. In this case, the liquid recovery layer 205, the first liquid recovery unit 202, the first processing main body 201, the second liquid recovery unit 204, and the second processing main body 203 are arranged in this order in the upward direction.

In order to feed the coating liquid to the liquid recovery layer 205 of the lowermost layer, the conventional substrate processing apparatus is configured as follows. In the lower processing unit U1, a first drain pipe 211 of the first processing main body 201 extends downward from the first processing main body 201 to the first liquid recovery unit 202.

On the other hand, in the upper processing unit U2, a second drain pipe 212 of the second processing main body 203 extends downward from the second processing main body 203 to the second liquid recovery unit 204. The second drain pipe 212 extends from the second liquid recovery unit 204 to the first liquid recovery unit 202 while bypassing a cup or the like of the first processing main body 201. The first drain pipe 211 is connected to the liquid recovery tank 207, and the second drain pipe 212 is connected to the liquid recovery tank 208.

As indicated by a two-dot chain line in FIG. 13, for example, in a case where the second drain pipe 212 passes through an inside of the first processing main body 201 when extending from the second liquid recovery unit 204 to the first liquid recovery unit 202, the first processing main body 201 and the second processing main body 203 have different structures (designs). Therefore, different structures are required for each of the first liquid recovery unit 202, the first processing main body 201, the second liquid recovery unit 204, and the second processing main body 203. Even in a case where the second drain pipe 212 passes through an outside of the first processing main body 201, the first liquid recovery unit 202 and the second liquid recovery unit 204 have different structures. When the first drain pipe 211 and the second drain pipe 212 are long, it is difficult to recover the coating liquid.

According to the present embodiment, the casing drainage flow path 55 formed to extend in the vertical direction Z is provided in the internal space SP1 of each of the processing casings 9A to 9C. In addition, the three casing drainage flow paths 55 of the three processing casings 9A to 9C are linearly connected. That is, when the three processing casings 9A to 9C are stacked, the three casing drainage flow paths 55 are linearly connected. Therefore, the drainage structure can be simplified.

In addition, since the casing drainage flow path 55 is provided in the internal space SP1, the casing drainage flow path 55 can be close to the cup 51 in the horizontal direction, whereby the connection flow path 57 can be shortened. In other words, the casing drainage flow path 55 is provided in the internal space SP1. Therefore, as compared with a case where the casing drainage flow path 55 is provided outside the processing casing 9 (for example, the processing casing 9B) and the casing drainage flow path 55 bypasses the lower processing casing 9 (for example, the processing casing 9A), the casing drainage flow path 55 can be close to the cup 51 in the horizontal direction and the connection flow path 57 can be shortened.

In addition, each of the three casing drainage flow paths 55 extends in the vertical direction Z, and the respective casing drainage flow paths 55 extending in the processing casings 9 are connected in the vertical direction Z, whereby the casing drainage flow paths 55 do not need to bypass the processing casings 9. In addition, since each of the three casing drainage flow paths 55 extends in the vertical direction Z, the flow of the coating liquid is facilitated while shortening each casing drainage flow path 55. Thus, the coating liquid can be efficiently recovered.

Further, for example, when the coating liquid has the high viscosity and the connection flow path 57 extends in the horizontal direction, it is particularly difficult to cause the coating liquid having the high viscosity to flow. According to the present embodiment, since the connection flow path 57 is inclined, it is possible to facilitate the flow of the processing liquid. In addition, since the connection flow path 57 extends linearly, the connection flow path 57 can be shortened.

In addition, each of the three processing casings 9A to 9C includes the standby pot 89 provided between the cup 51 and the casing drainage flow path 55 and capable of causing the coating liquid nozzle 33 to stand by, and the standby pot drainage flow path 91 for discharging the coating liquid received by the standby pot 89. The standby pot drainage flow path 91 is connected to the connection flow path 57 between the cup drainage flow path 53 and the casing drainage flow path 55. For example, when the standby pot 89, the cup 51, and the casing drainage flow path 55 are arranged in this order, the connection flow path 57 becomes long. In the present embodiment, the connection flow path 57 can be shortened.

The cup drainage flow path 53, the standby pot drainage flow path 91, and the casing drainage flow path 55 are disposed on a straight line in plan view. Accordingly, since the connection flow path 57 can be formed linearly, the connection flow path 57 can be shortened.

The standby pot drainage flow path 91 is formed to extend vertically downward from the standby pot 89. As a result, the flow of the coating liquid is facilitated while shortening the standby pot drainage flow path 91.

The casing drainage flow path 55 of each of the processing casings 9A and 9B includes the lower drainage flow path 77 extending vertically upward from the bottom hole 18 of the bottom wall 17A and the upper drainage flow path 78 extending vertically downward from the ceiling hole 19 of the ceiling wall 17B. The upper end of the lower drainage flow path 77 is separably coupled to the lower end of the upper drainage flow path 78. The upper drainage flow path 78 is detachably attached to the ceiling hole 19 of the ceiling wall 17B. For example, it is assumed that, in maintenance of the substrate processing apparatus 1, the upper drainage flow path 78 and the lower drainage flow path 77 are separated from each other, and then the upper drainage flow path 78 is detached from the ceiling hole 19 of the ceiling wall 17B. Since the upper drainage flow path 78 can expand and contract, the sufficient gap can be secured between the upper drainage flow path 78 and the lower drainage flow path 77. Therefore, the upper drainage flow path 78 can be easily detached from the ceiling hole 19 of the ceiling wall 17B.

In addition, the processing casing 9C is at the highest position among the three processing casings 9A to 9C. In this case, the casing drainage flow path 55 of each of the processing casings 9A and 9B includes the lower drainage flow path 77 and the upper drainage flow path 78. On the other hand, the casing drainage flow path 55 of the processing casing 9C includes the lower drainage flow path 77 and the lid member 105. In other words, the casing drainage flow path 55 of the processing casing 9C includes the lid member 105 instead of the upper drainage flow path 78. Therefore, each of the processing casings 9A and 9B can be easily changed to the processing casing 9C.

In addition, for example, it is assumed that the side wall 17C, the cup 51, the side wall 17D, and the casing drainage flow path 55 are arranged in this order in the horizontal direction. That is, it is assumed that the casing drainage flow path 55 is disposed outside the processing casing 9. In this case, if the cup 51 is disposed closer to the side wall 17C than the side wall 17D, the connection flow path 57 becomes longer, and it is difficult to secure the inclination of the connection flow path 57. According to the present embodiment, the casing drainage flow path 55 is disposed in the internal space SP1 (inside the processing casing 9). Therefore, the connection flow path 57 can be shortened, and the inclination of the connection flow path 57 can be secured.

### [Second embodiment]

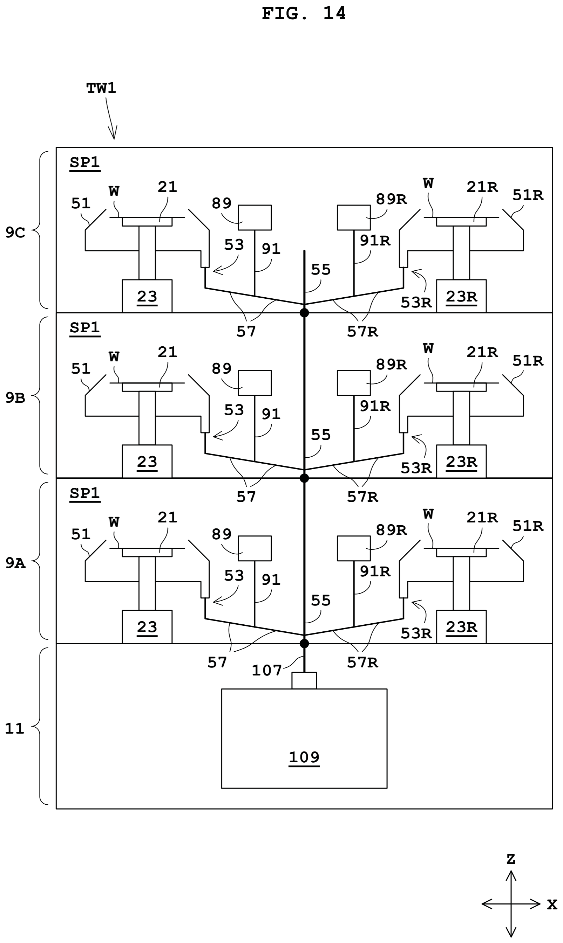

Next, a second embodiment of the present invention will be described with reference to the drawings. Note that the description common to the first embodiment will be omitted. FIG. 14 is a schematic diagram illustrating three processing casings 9A to 9C and a liquid recovery layer 11 stacked in the vertical direction Z according to the second embodiment.

In the first embodiment, each of the processing casings 9A to 9C includes the one spin chuck 21, the one cup 51, and the like. In this regard, in the second embodiment, each of the processing casings 9A to 9C includes two spin chucks 21 and 21R, two cups 51 and 51R, and the like.

Each of the three processing casings 9A to 9C further includes the spin chuck 21R, a rotation drive unit 23R, the cup 51R, a cup drainage flow path 53R, a connection flow path 57R, a standby pot 89R, and a standby pot drainage flow path 91R in an internal space SP1. The spin chuck 21R, the rotation drive unit 23R, the cup 51R, the cup drainage flow path 53R, the connection flow path 57R, the standby pot 89R, and the standby pot drainage flow path 91R are configured similarly to the spin chuck 21, the rotation drive unit 23, the cup 51, the cup drainage flow path 53, the connection flow path 57, the standby pot 89, and the standby pot drainage flow path 91, respectively.

The spin chuck 21R holds a substrate W. The cup 51R is formed to surround an outer peripheral edge of the spin chuck 21R, and receives a coating liquid scattered from the substrate W held by the spin chuck 21R. The cup drainage flow path 53R is formed to extend vertically downward from the cup 51R, and discharges the coating liquid received by the cup 51R.

The connection flow path 57R connects a lower end of the cup drainage flow path 53R and a casing drainage flow path 55. That is, the two connection flow paths 57 and 57R are both connected to the common casing drainage flow path 55.

The standby pot 89R is provided between the cup 51R and the casing drainage flow path 55, and can cause a coating liquid nozzle to stand by. The standby pot 89R can receive the coating liquid ejected from the coating liquid nozzle. The standby pot drainage flow path 91R is connected to the connection flow path 57R between the cup drainage flow path 53R and the casing drainage flow path 55.

Note that each of the three processing casings 9A to 9C may include a second ejection unit in addition to the ejection unit 25 illustrated in FIG. 5. The second ejection unit selectively ejects the coating liquid and a solvent to the substrate W held by the spin chuck 21R. The second ejection unit is configured similarly to the ejection unit 25. Note that each of the three processing casings 9A to 9C may not include the second ejection unit. In this case, the standby pot 89R and the standby pot drainage flow path 91R are not provided.

In addition, in a case where each of the three processing casings 9A to 9C does not include the second ejection unit, the ejection unit 25 may eject, for example, the coating liquid to the two substrates W respectively held by the two spin chucks 21 and 21R. Further, the two connection flow paths 57 and 57R may be arranged linearly in plan view. In addition, the two connection flow paths 57 and 57R may be arranged in an inverted V shape in plan view so that the ejection unit 25 does not interfere with the casing drainage flow path 55.

The spin chuck 21R corresponds to a second substrate holding unit or a second chuck of the present invention. The cup 51R corresponds to a second cup of the present invention. The cup drainage flow path 53R corresponds to a second cup drainage flow path of the present invention. The connection flow path 57R corresponds to a second connection flow path of the present invention.

According to the present embodiment, even when each of the plurality of processing casings includes the spin chuck 21R and the cup 51R, the coating liquid (processing liquid) can be efficiently recovered while simplifying the drainage structure.

The present invention is not limited to the above described embodiments, and can be modified as follows.
(1) In the above described embodiments, the cup-side flow path 73, the pot-side flow path 74, the lower flow path 75, and the connection flow path 57 are formed in the base member 71. In this respect, the cup-side flow path 73, the pot-side flow path 74, the lower flow path 75, and the connection flow path 57 may be formed in a tubular shape.
(2) In the above described embodiments and the modification (1), the ejection unit 25 includes the single coating liquid nozzle 33. In addition, the ejection unit 25 includes the single solvent nozzle 35. For these, the ejection unit 25 may include two or more coating liquid nozzles 33. In addition, the ejection unit 25 may include two or more solvent nozzles 35.
(3) In the above described embodiments and the modification, the tower TW1 includes the three processing casings 9A to 9C stacked in the vertical direction Z. In this regard, the tower TW1 may include two, or four or more processing casings 9.
(4) In the above described embodiments and the modification, each of the three processing casings 9A to 9C includes the standby pot 89. In this regard, when the standby pot 89 is unnecessary, each of the three processing casings 9A to 9C may not include the standby pot 89 and the standby pot drainage flow path 91.
(5) In the above described embodiments and the modification, the ejection unit 25 includes the coating liquid nozzle 33 that ejects the coating liquid. The liquid ejected from the nozzle is not limited to the coating liquid. For example, the ejection unit 25 may include a processing liquid nozzle instead of the coating liquid nozzle 33. The processing liquid nozzle may eject, for example, a developer or pure water as the processing liquid. Further, the processing liquid nozzle may eject a chemical solution. For example, a sulfuric acid-hydrogen peroxide mixture (SPM) which is a mixed liquid of sulfuric acid and hydrogen peroxide water may be ejected. The SPM is a chemical solution having a high viscosity, but according to the configuration described in the present embodiment, the SPM can be discharged to the outside of the apparatus without remaining in the casing drainage flow path 55. Although the embodiment of the modification of the present invention has been described using the SPM as an example, the chemical solution of the present invention is not limited to the SPM. When the chemical solution has the high viscosity, the same effect as described above can be obtained.

## Claims

1. A substrate processing apparatus that processes a substrate, comprising:
a plurality of processing casings stacked in a vertical direction, wherein
each of the plurality of processing casings includes, in an internal space,
a chuck configured to hold a substrate,
an ejection unit configured to eject a processing liquid to the substrate held by the chuck,
a cup formed to surround an outer peripheral edge of the chuck, and configured to receive the processing liquid scattered from the substrate held by the chuck,
a cup drainage flow path formed to extend vertically downward from the cup, and configured to discharge the processing liquid received by the cup,
a casing drainage flow path formed to extend in the vertical direction, and
a connection flow path connecting a lower end of the cup drainage flow path and the casing drainage flow path, and
the respective casing drainage flow paths of the plurality of processing casings are connected as the plurality of processing casings are stacked in the vertical direction.

2. The substrate processing apparatus according to claim 1, wherein
the connection flow path is formed to be inclined downward and in a direction toward the casing drainage flow path.

3. The substrate processing apparatus according to claim 2, wherein
the connection flow path is formed to extend linearly.

4. The substrate processing apparatus according to any one of claims 1 to 3, wherein
each of the plurality of processing casings further includes, in the internal space,
a standby pot provided between the cup and the casing drainage flow path, the standby pot configured to cause the ejection unit to stand by, and configured to receive the processing liquid ejected from the ejection unit, and
a standby pot drainage flow path configured to discharge the processing liquid received by the standby pot, and
the standby pot drainage flow path is connected to the connection flow path between the cup drainage flow path and the casing drainage flow path.

5. The substrate processing apparatus according to claim 4, wherein
the cup drainage flow path, the standby pot drainage flow path, and the casing drainage flow path are arranged on a straight line in plan view.

6. The substrate processing apparatus according to claim 5, wherein
the standby pot drainage flow path is formed to extend vertically downward from the standby pot.

7. The substrate processing apparatus according to any one of claims 1 to 3, wherein
each of the plurality of processing casings includes a cleaning liquid ejection unit configured to eject a cleaning liquid to the connection flow path, and
the cleaning liquid ejection unit is provided at a proximal end portion of the connection flow path to which the cup drainage flow path is connected.

8. The substrate processing apparatus according to any one of claims 1 to 3, wherein
the plurality of processing casings include a first processing casing, and a second processing casing disposed on an upper portion of the first processing casing,
the first processing casing includes
a first bottom wall that defines a lower surface of a first internal space that is the internal space of the first processing casing, and
a ceiling wall that defines an upper surface of the first internal space,
the first bottom wall includes a first bottom hole,
the ceiling wall includes a ceiling hole,
the casing drainage flow path of the first processing casing includes
a lower drainage flow path attached to the first bottom hole, and formed to extend vertically upward from the first bottom hole, and
an upper drainage flow path capable of expanding and contracting, the upper drainage flow path detachably attached to the ceiling hole and formed to extend vertically downward from the ceiling hole, and
an upper end of the lower drainage flow path is separably coupled to a lower end of the upper drainage flow path.

9. The substrate processing apparatus according to claim 8, wherein
the second processing casing is at a highest position among the plurality of processing casings,
the second processing casing includes a second bottom wall that defines a lower surface of a second internal space that is the internal space of the second processing casing,
the second bottom wall includes a second bottom hole, and
the casing drainage flow path of the second processing casing includes
a lower drainage flow path attached to the second bottom hole, and formed to extend vertically upward from the second bottom hole, and
a lid member configured to close an upper end of the lower drainage flow path.

10. The substrate processing apparatus according to any one of claims 1 to 3, wherein
each of the plurality of processing casings further includes a first side wall and a second side wall that define two side surfaces of the internal space and face each other,
the cup is disposed closer to the first side wall than the second side wall, and
the casing drainage flow path is disposed on an opposite side of the first side wall with the cup interposed therebetween.

11. The substrate processing apparatus according to any one of claims 1 to 3, wherein
each of the plurality of processing casings further includes, in the internal space,
a second chuck configured to hold a second substrate,
a second cup formed to surround an outer peripheral edge of the second chuck, and configured to receive the processing liquid scattered from the second substrate held by the second chuck,
a second cup drainage flow path formed to extend vertically downward from the second cup, and configured to discharge the processing liquid received by the second cup, and
a second connection flow path connecting a lower end of the second cup drainage flow path and the casing drainage flow path.

12. The substrate processing apparatus according to any one of claims 1 to 3, wherein
the ejection unit is configured to eject a coating liquid as the processing liquid to the substrate held by the chuck.

13. The substrate processing apparatus according to any one of claims 1 to 3, wherein
the respective casing drainage flow paths provided in the plurality of processing casings are arranged so as to at least partially overlap each other in plan view.

14. The substrate processing apparatus according to claim 13, wherein
the respective casing drainage flow paths of the plurality of processing casings are linearly connected as the plurality of processing casings are stacked in the vertical direction.
